# EUROPEAN PATENT APPLICATION

(11) **EP 4 851 584 A1**
(43) Date of publication of application: **09.12.2026**
(21) Application number: 26179518.1
(22) Date of filing: 19.05.2026
(51) Int. Cl.: G01D 5/14, G01D 11/24, G01R 33/00, H05K 1/18

(54) **DISPLACEMENT SENSOR FOR CONTACTLESS MEASURING A POSITION OF A MAGNET, AND SENSOR ARRANGEMENT WITH A PLURALITY OF SENSORS**

(30) Priority: 06.06.2025 DE 102025122385
(71) Applicant: Piher Sensors & Controls, S.A., 31500 Tudela (Navara) (ES)
(72) Inventor: Gurría Paúl, Jaime, 26550 Rincon de Soto (ES); Vanneste Claerbout, Bram Erik, 31500 Tudela (ES)
(74) Representative: Staeger & Sperling Partnerschaftsgesellschaft mbB

(57) **Abstract**

The invention relates to a displacement sensor (1) for contactless measuring a position of a magnet (M) along a sensor measurement path (10) along which the magnet (M) is movable, having a plurality of magnetic field sensors (21, 22, 23), which each has a predefined displacement measurement range (24), wherein the displacement measurement ranges (24) directly abut each other along the sensor measurement path (10) without overlapping, so that the displacement measurement ranges (24) together cover the entire sensor measurement path (10), and wherein a calculation unit (11) is configured to determine the magnetic field sensor (21, 22, 23) in whose displacement measurement range (24) the magnet (M) is positioned as selected magnetic field sensor (12), and to calculate the position of the magnet (M) along the sensor measurement path (10), in particular exclusively based on the output signal (S) of the selected magnetic field sensor (12).

## Description

The invention relates to a displacement sensor for contactless measuring a position of a magnet, as well as to a sensor arrangement with a plurality of sensors, of which preferably at least two sensors are displacement sensors according to the invention.

A wide variety of displacement sensors and sensor arrangements are known from the prior art. If magnetic field sensors are used to detect a position of a magnet, the problem arises that their measurement error increases as the distance between the magnet and the magnetic field sensor increases.

To overcome this problem, publication DE 10 2012 205 902 A1 and WO 2013/153005 A1, which is based thereon, propose that several magnetic field sensors are arranged in series along a measurement path along which the magnet whose position is to be detected is movable. Two adjacent magnetic field sensors overlap in terms of their detection range in an overlap area. If the magnet is positioned within the overlap area, the position of the magnet is determined from an output signal from both magnetic field sensors. If the magnet is not positioned within the overlap area, the position of the magnet is determined from the output signal of the magnetic field sensor in whose detection range the magnet is positioned.

However, this has two significant disadvantages. On the one hand, the position of the magnet must first be determined with a sufficiently high probability so that it can be reliably assigned to the overlap area, and on the other hand, the subsequent calculation of the position in the overlap area based on two output signals requires a comparatively complex calculation, which is more time-consuming and, due to the computing power that may be required, more expensive than an otherwise simpler calculation of the position.

The invention is therefore aimed at overcoming the aforementioned disadvantages and providing a displacement sensor for simplified and cost-effective contactless measuring a position of a magnet along a sensor measurement path, as well as a robust and cost-effective sensor arrangement, which preferably comprises at least two such displacement sensors.

This task is solved by the combination of features according to the independent patent claims.

According to the invention, a displacement sensor is therefore proposed for contactless measuring a position of a magnet along a sensor measurement path, wherein the magnet is movable along the sensor measurement path or can be movably arranged on it. The displacement sensor is used to determine the position of the magnet, so that the magnet is not necessarily part of the displacement sensor. The displacement sensor has a calculation unit and a plurality of magnetic field sensors, which are connected to the calculation unit, in particular electrically and/or by means of signals, and are arranged in series along the sensor measurement path. Each magnetic field sensor is configured to output an output signal to the calculation unit, which corresponds i. e. relates to a position of the magnet along a respective magnetic field sensor axis. The respective output signal is preferably at least one magnetic field value, which can be used to calculate the respective position of the magnet. This means that the output signal does not have to be the position of the magnet directly, but the position of the magnet can be determined from the output signal as the position of the magnet along the magnetic field sensor axis can be calculated or determined from the output signal or its one or more in particular two magnetic field values. Furthermore, each magnetic field sensor has a predefined displacement measurement range along its respective magnetic field sensor axis, in which the position is determinable with an accuracy within a predefined error tolerance. It is essential for the invention that the displacement measurement ranges directly abut each other, i. e. are directly adjacent and in direct contact to each other, along the sensor measurement path without overlapping, so that the displacement measurement ranges together cover the entire sensor measurement path, wherein the calculation unit is configured to determine the magnetic field sensor in whose displacement measurement range the magnet is positioned, and to calculate the position of the magnet along the sensor measurement path based on the output signal of the magnetic field sensor and preferably exclusively on the basis of the output signal of the magnetic field sensor in whose displacement measurement range the magnet is positioned, so that the output signals of the other magnetic field sensors are not used for calculating the position of the magnet, thereby significantly simplifying the calculation.

Although the magnetic field sensors can be arranged parallel to the sensor measurement path, for example, it is also possible to arrange the magnetic field sensors alternating on both sides of the sensor measurement path or along an axis that is tilted by 2 to 3° relative to the sensor measurement path.

Furthermore, the calculation unit is preferably configured to output a sensor signal that is linearly related to the position of the magnet along the sensor measurement path, so that the position can be output as a voltage, for example.

The position of the magnet along the sensor measurement path is preferably determined starting from a reference point, which may be located, for example, at the beginning of the sensor measurement path or at its centre.

According to an advantageous embodiment, the magnetic field sensors are 3D magnetic sensors. In this case, the output signal of each magnetic field sensor to the calculation unit comprises separate values that are indicative of a magnetic field along at least two different axes, in particular along an x-axis and a z-axis. The axes mentioned are merely examples, as the separate values in a different configuration can be indicative, for example, of the magnetic field along the x-axis and the y-axis. The calculation unit is configured to calculate a single arithmetic value from the separate values, which corresponds to the position of the magnet along the respective magnetic field sensor axis. The arithmetic value is preferably an arc tangent of a division of the separate values.

Although the position of the magnet along the sensor measurement path can be calculated using a corresponding stored mathematical function, according to another advantageous embodiment, the calculation unit is configured to calculate the position of the magnet along the sensor measurement path using at least one look-up table that references the respective output signals and/or the arithmetic values to a position of the magnet along the displacement measurement ranges and/or along the sensor measurement path.

An advantageous embodiment of this provides that the calculation unit is configured to first determine the orientation of the poles of the magnet along the sensor measurement path from the output signal of at least one of the magnetic field sensors and preferably from the output signal of the selected magnetic field sensor, so that it is known whether the magnet is being moved in an S-N or N-S orientation along the sensor measurement path. Furthermore, the calculation unit is designed to calculate the position of the magnet along the sensor measurement path using at least one look-up table specific to the orientation of the poles of the magnet, which references the respective output signals and/or the arithmetic values to a position of the magnet along the displacement measuring ranges and/or along the sensor measurement path. Consequently, in this variant, at least two reference tables, one for an S-N alignment and one for an N-S alignment, can be retrieved from or stored in the calculation unit.

When calculating the position using a look-up table, it is preferable to compare the output signals or arithmetic values calculated from the output signals with table values stored in one of the lookup tables, for each of which a position of the magnet along the sensor measurement path or along a respective magnetic field sensor axis is stored, so that the position can be determined immediately by comparison with the table values or, for example, by interpolation between two closest table values.

Since the actual calculation of the position of the magnet along the sensor measurement path requires the prior determination of the selected magnetic field sensor, three alternative variants provide very simple determination methods that can be implemented without great computational effort.

According to a first variant, the calculation unit is configured to determine the selected magnetic field sensor by acquiring a respective value from the output signals of all magnetic field sensors, which corresponds to the respective position of the magnet along the respective magnetic field sensor axis. The magnetic field sensor is then determined to be the selected magnetic field sensor in whose displacement measurement range the position corresponding to the respective value is located.

In this case, it is advantageous that any number of magnetic field sensors can be positioned along the sensor measurement path. However, this usually requires a number of comparisons equal to the number of magnetic field sensors in order to determine the selected magnetic field sensor.

Since it is often advantageous and sufficient to provide only two magnetic field sensors along the sensor measurement path, a second variant provides that the displacement sensor preferably has exactly two magnetic field sensors, i.e. a first magnetic field sensor and a second magnetic field sensor. Here, the calculation unit is configured to determine the selected magnetic field sensor by acquiring a value by the output signal of the first magnetic field sensor, which corresponds to the position of the magnet along the magnetic field sensor axis of the first magnetic field sensor. The first magnetic field sensor is then determined to be the selected magnetic field sensor if the position corresponding to the value is within the displacement measurement range of the first magnetic field sensor. Furthermore, the second magnetic field sensor is determined to be the selected magnetic field sensor if the position corresponding to the value is outside the displacement measurement range of the first magnetic field sensor.

To clarify, only one comparison is necessary with this variant, as only one value corresponding to the position is used and the conclusion regarding the selected magnetic field sensor is drawn from the comparison.

Based on preferably exactly three magnetic field sensors, a third advantageous variant provides that the displacement sensor has a first magnetic field sensor and a third magnetic field sensor as well as a second magnetic field sensor, which is arranged between the first magnetic field sensor and the third magnetic field sensor. It is provided that the calculation unit is configured to determine the selected magnetic field sensor by acquiring a value by the output signal of the second magnetic field sensor, which corresponds to the position of the magnet along the magnetic field sensor axis of the second magnetic field sensor. The second magnetic field sensor is then determined to be the selected magnetic field sensor if the position corresponding to the value is within the displacement measurement range of the second magnetic field sensor. Furthermore, the first magnetic field sensor is determined to be the selected magnetic field sensor if the position corresponding to the value is located on a side facing the first magnetic field sensor outside the displacement measurement range of the second magnetic field sensor. Consequently, the third magnetic field sensor is determined to be the selected magnetic field sensor if the position corresponding to the value is located on a side facing the third magnetic field sensor outside the displacement measurement range of the second magnetic field sensor and/or if the position corresponding to the value is located outside the displacement measurement range of the second magnetic field sensor and not on a side facing the third magnetic field sensor outside the displacement measurement range of the second magnetic field sensor.

It should also be made clear with regard to this variant that only two comparisons may be necessary, as only one value corresponding to the position has to be compared to the displacement measurement range of the second magnetic field sensor and, if necessary, with one of the limit values of the displacement measurement range, and then a conclusion can be drawn with regard to the selected magnetic field sensor.

In each of the three variants mentioned, it should be noted that the respective positions along the magnetic field sensor axes can be determined, but do not have to be determined. For example, the respective value corresponding to the position can also be compared with a table or a value range corresponding to the displacement measurement range, so that a prior calculation of the position is unnecessary.

Another aspect of the invention relates to a sensor arrangement with a central calculation unit and a plurality of sensors. At least two of the plurality of sensors are displacement sensors according to the invention. It is further provided that the calculation units of the displacement sensors are integrated or combined in the central calculation unit and that the plurality of magnetic field sensors of the displacement sensors are connected or connectable to the central calculation unit, in particular electrically and/or by means of signals.

Furthermore, a sensor arrangement with a central calculation unit and a plurality of sensors is proposed, in which it may be provided that at least two of the plurality of sensors are displacement sensors according to the invention, wherein the calculation units of the displacement sensors are integrated or combined in the central calculation unit, and the plurality of magnetic field sensors of the displacement sensors can be connected to the central calculation unit, in particular electrically and/or in terms of signals. In such a sensor arrangement, however, it is essential that the sensor arrangement has a housing base and, for each sensor, a sensor carrier with at least one sensor mount. The housing base and the sensor carriers can be formed in one piece, i. e. integrally, with each other. At the respective sensor mount, the respective sensor is held at an individually predetermined distance from the housing base, i.e. specific to this sensor, and/or at a predetermined detection distance from an object to be detected by the respective sensor.

If, for example, three sensor carriers are provided, the three sensors carried by them can be spaced differently from the housing base and oriented differently, so that the three sensors can be positioned independently of each other and optimally for detecting a respective measured variable or for detecting a respective object.

According to a further embodiment of such a sensor arrangement, it is proposed that at least one sensor carrier has a first sensor mount on which the respective sensor can be arranged essentially parallel to a plane defining the housing base, and a second sensor mount on which the respective sensor can be arranged tilted, in particular orthogonally to the plane.

Furthermore, it may be provided that the sensor arrangement comprises a one-piece i. e. integrally formed rigid-flex printed circuit board with a rigid central section, on which the central calculation unit is arranged or with which the central calculation unit is connectable, and a rigid sensor section per sensor, which are each electrically connected to the central section via a flexible connection section. The rigid-flex printed circuit board is configured to be pre-assembled, i.e. can be equipped with electronic components, and configured to be mounted in the sensor arrangement with the sensors connectable to the central calculation unit in such a way that the central section is arranged on the housing base and the sensor sections are each arranged on a corresponding sensor mount, so that the flexible connection sections extend from the housing base, for example, along the sensor carriers to the sensors.

In principle, the central calculation unit can be arranged within a chamber formed by the housing base and main housing and/or on the central section of the rigid-flex printed circuit board. Alternatively, however, it may be provided that the central calculation unit is arranged outside a housing formed by the housing base and main housing and can, for example, be integrated into a higher-level system. In this case, a connection section may be provided on the rigid-flex printed circuit board, which, for example, enables a connection to the externally provided central processing unit via a plug connection.

If the flexible connection sections are designed with a predetermined length greater than the length required for a specific sensor arrangement, such a rigid-flex printed circuit board can also be used for different sensor arrangements or for different housing bases, in which the corresponding sensor carriers extend different distances from the housing base.

Furthermore, such a rigid-flex printed circuit board may have additional rigid sections, for example a rigid connector section, which may each be connected to the rigid central section via flexible connection sections. The rigid central section and/or the rigid sensor sections may also be separated into several parts connected by flexible connection sections.

In addition, it may be provided that the sensor arrangement further comprises a main housing, which is arranged on the housing base and encloses at least one of the sensors. The main housing has a receiving pot for each enclosed sensor, which forms a hollow, liquid-tight sensor chamber that receives the respective sensor, whereby the sensor chamber is preferably open to the housing base in accordance with the pot-like design.

The main housing and the housing base can be designed to lock together, whereby a sealing surface can also be formed between them so that they can be fixed together in a liquid-tight manner.

Furthermore, the main housing and the housing base can be connected to each other in a material-locking manner, for example by ultrasonic welding.

It is particularly advantageous that at least one opening is provided in the housing base, which is connected fluidically to at least one sensor chamber. Preferably, exactly one opening is provided per sensor chamber, which is connected fluidically with the respective sensor chamber through the respective sensor carrier. Through the opening, a sealing compound, which can be cured in the sensor chamber, can be filled into the sensor chamber, in particular by means of gravity, which completely encloses the sensor arranged in the sensor chamber. Although the sealing compound is preferably liquid when poured through the opening, viscous, pre-meltable or granular sealing compounds can also be used, for example. The sealing compound can be, for example, a synthetic resin, in particular epoxy resin, or a thermoplastic hot melt.

Furthermore, it may be provided that a sealing portion surrounding the receiving pot is formed on an outer side of at least one of the receiving pots facing away from the sensor chamber. Such a sealing portion allows the receiving pot to be inserted into a corresponding opening in a liquid-tight manner. Alternatively or additionally, such a sealing portion may also be provided on an area of the main housing adjacent to a base of at least one of the receiving pots.

Although all sensors may be of the same type, it may also be provided that the sensor arrangement comprises different types of sensors. For example, at least one of the plurality of sensors may be a temperature sensor. In addition or alternatively, at least one of the plurality of sensors may be a speed sensor.

An acceleration sensor, for example, would also be possible.

For the sensors, and in particular for a temperature sensor and a speed sensor, it is also possible for several sensors to be integrally combined with one another and, for example, to be formed on a common rigid sensor section.

The features disclosed above can be combined in any way that is technically possible and does not conflict with each other.

Other advantageous embodiments of the invention are indicated in the dependent claims or are described in more detail below together with the description of the preferred embodiment of the invention with reference to the figures. They show:
- Fig. 1 - 5: different designs of a displacement sensor;
- Fig. 6: schematic output signal / arithmetic value of a magnetic field sensor;
- Fig. 7: schematic output signals / arithmetic values of two magnetic field sensors arranged in series;
- Fig. 8: a sensor arrangement;
- Fig. 9: a sensor arrangement separated into its main components;
- Fig. 10: detailed view of a rigid-flex printed circuit board arranged on the housing base;
- Fig. 11: detailed view of a cross-section through the sensor arrangement.

The figures are exemplary and schematic. Identical reference symbols in the figures indicate identical functional and/or structural features.

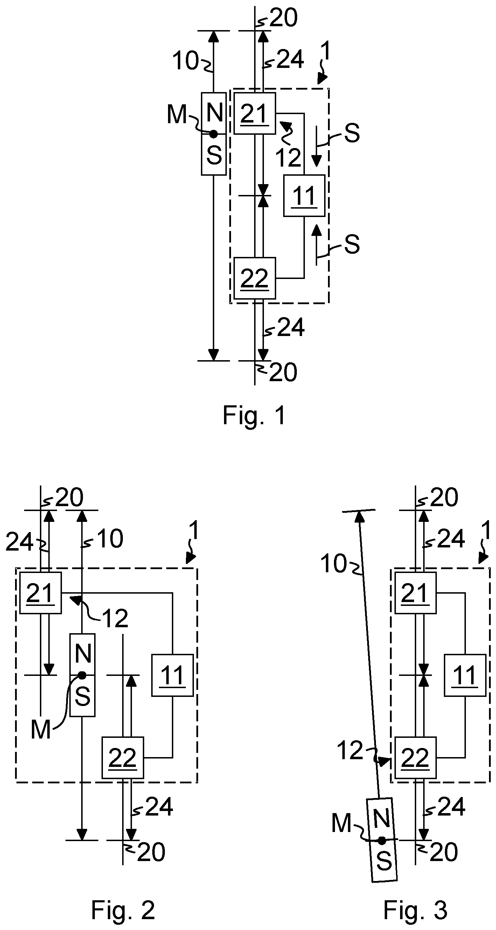

Figures 1 to 5 show different variants of a displacement sensor 1 according to the invention.

The embodiments shown in Figures 1 to 3 are displacement sensors 1, each with a first magnetic field sensor 21 and a second magnetic field sensor 22, which are connected to a calculation unit 11 for signal processing. The displacement sensor 1 enables contactless measurement of the position of a magnet M, which is movable along a sensor measurement path 10. The magnet M is not necessarily part of the displacement sensor 1.

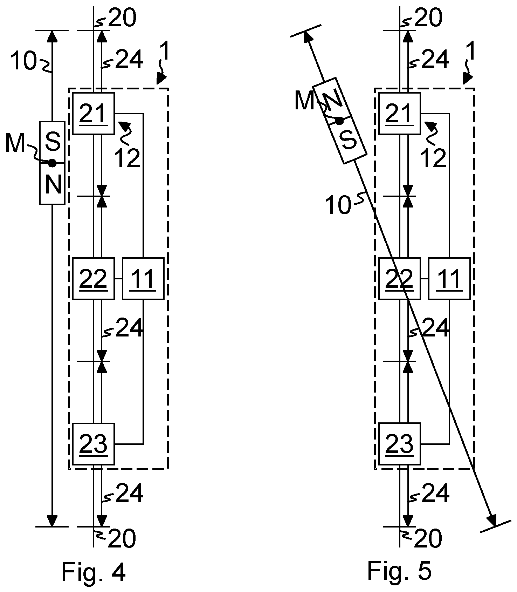

Figures 4 and 5 show embodiments of the displacement sensor 1, each of which has a first magnetic field sensor 21, a second magnetic field sensor 22 and a third magnetic field sensor 23, which are connected to a calculation unit 11 for signal processing. This allows the position to be detected with greater accuracy compared to the variants shown in figures 1 to 3 with the same sensor measurement path 10, or with the same accuracy with a longer sensor measurement path 10.

It should be noted that each of the magnetic field sensors 21, 22, 23 outputs an output signal S to the calculation unit 11, which corresponds to the position P of the magnet M along a magnetic field sensor axis 20 of the respective magnetic field sensor 21, 22, 23.

Such an output signal S may, for example, be a voltage and change linearly dependent on the position P of the magnet M along the magnetic field sensor axis 20, but it is preferably provided that the output signals S are not a single value or a voltage indicating the position P.

According to the embodiments shown, it is provided that the magnetic field sensors 21, 22, 23 are 3D magnetic field sensors which indicate at least two magnetic field values along mutually orthogonal axes, e.g. an x-axis and a y-axis, as the output signal S. These two magnetic field values in turn allow the position P to be determined by converting them to a single arithmetic value.

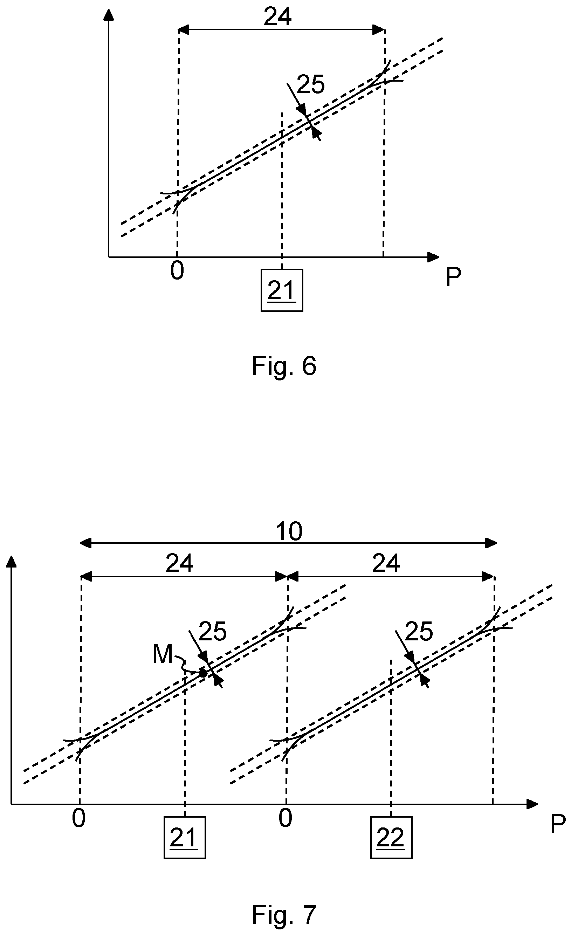

Figure 6 shows an example of a linear relationship, whereby the ordinate of the graph shown can be understood directly as an output signal S representing a single value or, alternatively, as an arithmetic value determined from two separate values of an output signal S.

Along the magnetic field sensor axis 20, there is a predefined displacement measurement range 24 for each magnetic field sensor 21, 22, 23, in which the position P of the magnet M along the respective magnetic field sensor axis 20 can be determined with an accuracy within a predefined error tolerance 25, as also shown in figure 6.

In order to enable contactless determination of the position of the magnet M along the entire sensor measurement path 10 with an accuracy within the predefined error tolerance 25, the invention essentially provides that the displacement measurement ranges 24 along the sensor measurement path 10 are directly adjacent to each other without overlapping, so that the displacement measurement ranges 24 together cover the entire sensor measurement path 10, wherein the calculation unit 11 is configured to determine the magnetic field sensor 21, 22, 23 in whose displacement measurement range 24 the magnet M is positioned as the selected magnetic field sensor 12 and to calculate the position of the magnet M along the sensor measurement path 10 exclusively on the basis of the output signal S of the selected magnetic field sensor 12.

Accordingly, the selected magnetic field sensor 12 must be determined before the actual calculation of the position of the magnet M along the sensor measurement path 10.

For this purpose, the output signals S of the magnetic field sensors 21, 22, 23 can simply be compared and the magnetic field sensor 21, 22, 23 whose output signal S is strongest or closest to the magnet M can be determined as the selected magnetic field sensor 12.

Alternatively, the output signals S of the magnetic field sensors 21, 22, 23 can also be evaluated to determine whether the corresponding position P of the magnet M lies within the displacement measurement range 24 of one of the magnetic field sensors 21, 22, 23 which then can be used as the selected magnetic field sensor 12.

If the selected magnetic field sensor 12 is known, the position of the magnet M along the sensor measurement path 10 can be determined solely from its output signal S, i.e. without using the output signals S of the other magnetic field sensors, and with the aid of a corresponding mathematical formula or a look-up table.

In the example of the variant shown in Figure 1, the first magnetic field sensor 21 is determined as the selected magnetic field sensor 12. Its output signal S indicates the position of the magnet M within the predetermined error tolerance 25 and thus with sufficient accuracy so that the position of the magnet M can be determined directly as shown in Figure 7. The same applies to Figure 7 as to Figure 6.

According to the variant shown in Figure 2, it is essential that the magnetic field sensors 21, 22 can also be arranged alternating along the sensor measurement path 10.

Furthermore, as shown in Figure 3, the magnetic field sensors 21, 22 can be arranged along a common axis so that their magnetic field axes 20 are coaxial, whereby this common axis can be tilted relative to the sensor measurement path 10.

With regard to the variant shown in Figure 4, it is essential that the position of magnet M along sensor measurement path 10 can also be determined taking into account the orientation of magnet M. Figure 4 shows an example of an orientation of the poles of magnet M that is reversed in comparison to Figures 1 to 3, which can be detected by calculation unit 11 on the basis of an output signal S from at least one magnetic field sensor 21, 22, 23 designed as a 3D magnetic field sensor. For each possible orientation of the magnet M, a respective look-up table can then be stored in the calculation unit 11, which is used to calculate the position of the magnet M along the sensor measurement path 10.

The variant according to Figure 5 illustrates that the sensor measurement path 10 can not only be tilted relative to the coaxial magnetic field sensor axes 20, but can also cross them in the area of one of the displacement measurement ranges 24.

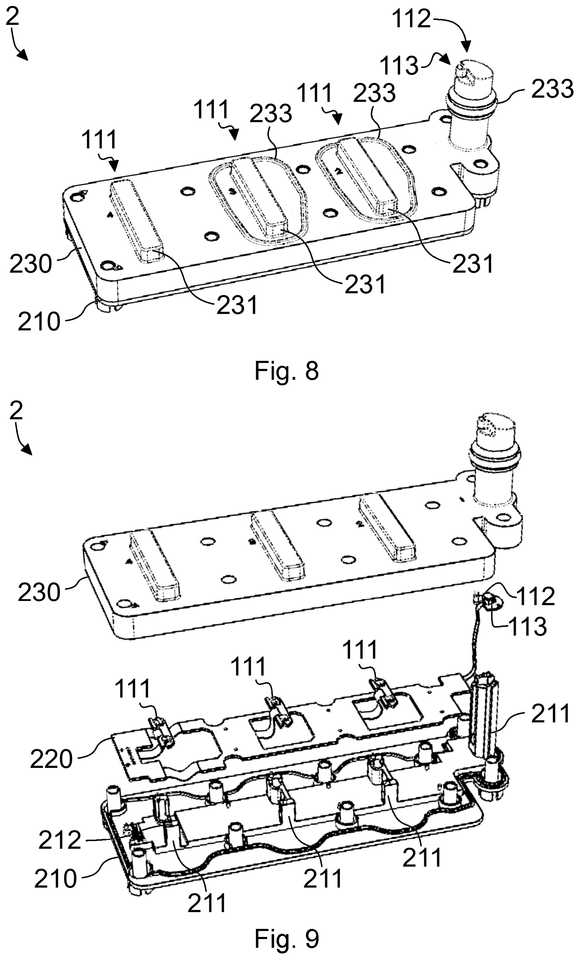

Figures 8 to 11 each show a sensor arrangement 2 with three displacement sensors 1 in different views.

Basically, a sensor arrangement 2 is shown with a housing formed by a housing base 210 and a main housing 230, in which a plurality of sensors 111, 112, 113 are accommodated, wherein in the present case three sensors 111 are displacement sensors 1 according to the invention.

The sensor arrangement 2 also has a central calculation unit, which can be located in the housing and, for example, on the rigid-flex printed circuit board 220 or externally, outside the housing, and is not shown here.

However, since the three sensors 111 are displacement sensors 1, it should be noted that the calculation units 11 of the displacement sensors 1 are jointly designed as or in the central calculation unit.

An advantage of the sensor arrangement 2 shown is that the individual sensors 111, 112, 113 are each arranged in a receiving pot 231 formed by the main housing 230. For exemplary purposes, the three sensors 111 designed as displacement sensors 1 are arranged on a common plane and at the same distance from the housing base 210, whereby these may also be located on different planes relative to one another and thus have different distances from the housing base 210. The other sensors 112, 113 are spaced at a different distance from the housing base 210 than the sensors 111 designed as displacement sensors, whereby the sensors 111, 112, 113 each have an arrangement that is optimal for the measurement to be performed.

As also shown in Figure 8, sealing sections 233 are provided around some of the receiving pots 231 so that the sensor arrangement 2 provided with sealing sections 233 can be positioned on a body on which the receiving pots 231 extend in a sealed manner through corresponding openings.

Figure 9 shows the three main components of the sensor arrangement 2, i.e. the housing base 210, the main housing 230 and the rigid-flex printed circuit board 220 enclosed by these, in an exploded view, so that the sensor carriers 211 formed integrally with the housing base 210 are visible, which determine the distance of the sensors 111, 112, 113 from the housing base 210 or a plane defining the housing base 210.

It is also clear that, in addition to the displacement sensors 1 as sensors 111 of the sensor arrangement 2, a temperature sensor 112 and a speed sensor 113 are also provided, which are formed on a common section of the rigid-flex printed circuit board 220.

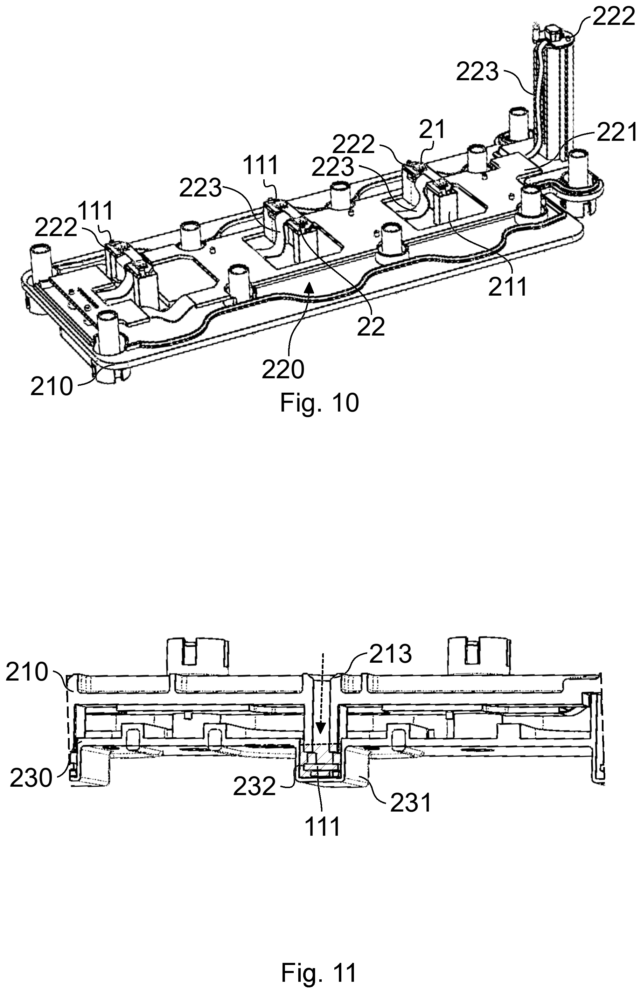

The use of a rigid-flex printed circuit board 220, as shown in detail in Figure 10, is advantageous because such a printed circuit board can be pre-assembled, i.e. equipped with all the necessary electrical components, before being mounted on the housing base 210 and then mounted in the desired position.

It is therefore a one-piece, single-piece printed circuit board which has rigid sections 221, 222 connected by flexible connection sections 223.

Specifically, for each sensor 111 designed as a displacement sensor 1, there is a rigid sensor section 222 on which the magnetic field sensors 21, 22 of the respective sensor 111 are arranged. The temperature sensor 112 and the speed sensor 113 are provided on a common rigid sensor section 222, whereby all sensor sections 222 are connected to a two-part central section 221 via respective flexible connecting sections 223.

The flexible connecting sections 223 thus make it possible during assembly to position the sensors 111, 112, 113 and the entire printed circuit board 220 as desired without the need for further electrical contacting.

Figure 10 also shows the sensor mounts 212 on the sensor carriers 211, on which the sensors 111 can be arranged in a predetermined orientation.

Figure 11 discloses a particularly advantageous aspect of the sensor arrangement 2. In the housing base 210, there is an opening 213 for each mounting pot 231, which are fluidically connected to a sensor chamber 232 formed by the respective receiving pot 231 around the respective sensors 111, 112, 113. A sealing compound which is curable in the sensor chamber 232 can then be filled into the sensor chamber 232 through the respective opening 213, which completely encloses and thus both mechanically protects and seals the sensor 111, 112, 113 arranged in the sensor chamber 232.

As shown, the sealing compound can extend into the opening 213 or a channel leading to the opening 213, so that the sealing compound not only fills the sensor chamber 232 but also seals the housing.

The invention is not limited in its execution to the preferred embodiments described above. Rather, a number of variants are conceivable which make use of the solution described, even in fundamentally different embodiments.

## Claims

1. Displacement sensor (1) for contactless measuring a position of a magnet (M) along a sensor measurement path (10) along which the magnet (M) is movable,
wherein the displacement sensor (1) comprises a calculation unit (11) and a plurality of magnetic field sensors (21, 22, 23), which are connected to the calculation unit (11) and arranged in series along the sensor measurement path (10),
wherein each magnetic field sensor (21, 22, 23) is configured to output an output signal (S) to the calculation unit (11) that corresponds to a position (P) of the magnet (M) along a respective magnetic field sensor axis (20),
wherein each magnetic field sensor (21, 22, 23) has a predefined displacement measurement range (24) along its respective magnetic field sensor axis (20) in which said position (P) is determinable with an accuracy within a predefined error tolerance (25),
wherein the displacement measurement ranges (24) directly abut each other along the sensor measurement path (10) without overlapping, so that the displacement measurement ranges (24) together cover the entire sensor measurement path (10),
and wherein the calculation unit (11) is configured to determine the magnetic field sensor (21, 22, 23) in whose displacement measurement range (24) the magnet (M) is positioned as selected magnetic field sensor (12), and to calculate the position of the magnet (M) along the sensor measurement path (10), in particular exclusively based on the output signal (S) of the selected magnetic field sensor (12).

2. Displacement sensor according to claim 1,
wherein the magnetic field sensors (21, 22, 23) are 3D magnetic sensors,
and wherein the output signal (S) of each magnetic field sensor (21, 22, 23) to the calculation unit (11) comprises separate values indicative for a magnetic field along at least two different axes, in particular along an x-axis and an z-axis,
wherein the calculation unit (11) is configured to calculate a single arithmetic value from said separate values as value corresponding to the position (P) of the magnet (M) along the respective magnetic field sensor axis (20) and in particular an arctangent as arithmetic value by a division of said separate values.

3. Displacement sensor according to claim 1 or 2,
wherein the calculation unit (11) is configured to calculate the position of the magnet along the sensor measurement path by at least one look-up table, which references the respective output signals (S) and/or the arithmetic values to a position (P) of the magnet (M) along the displacement measurement ranges 824) and/or to a position of the magnet (M) along the sensor measurement path (10).

4. Displacement sensor according to the preceding claim,
wherein the calculation unit (11) is configured to determine the orientation of the poles of the magnet (11) along the sensor measurement path (10) from the output signal (S) of at least one of the magnetic field sensors (21, 22, 23) and to calculate the position of the magnet (M) along the sensor measurement path (10) by at least one look-up table specific to the orientation of the poles of the magnet (M), which references the respective output signals (S) and/or the arithmetic values to a position (P) of the magnet (M) along the displacement measurement ranges (24) and/or to a position (P) of the magnet (M) along the sensor measurement path (10).

5. Displacement sensor according to one of the preceding claims,
wherein the calculation unit (11) is configured to determine the selected magnetic field sensor (12) by
acquiring a respective value by the output signals (S) of all magnetic field sensors (21, 22, 23), which corresponds to the respective position (P) of the magnet (M) along the respective magnetic field sensor axis (20), and determining the magnetic field sensor (21, 22, 23) as selected magnetic field sensor (12) in whose displacement measurement range (24) the position (P) corresponding to the respective value is located.

6. Displacement sensor according to one of the preceding claims 1 to 4,
wherein the displacement sensor (1) has a first magnetic field sensor (21) and a second magnetic field sensor (22) and
the calculation unit (11) is configured to determine the selected magnetic field sensor (12) by
acquiring a value by the output signal (S) of the first magnetic field sensor (S), which corresponds to the position (P) of the magnet (M) along the magnetic field sensor axis (20) of the first magnetic field sensor (21) and
determining the first magnetic field sensor (21) to be the selected magnetic field sensor (12) if the position (P) corresponding to the value is within the displacement measurement range (24) of the first magnetic field sensor (21) and
determining the second magnetic field sensor (22) to be the selected magnetic field sensor (12) if the position (P) corresponding to the value is outside the displacement measurement range (24) of the first magnetic field sensor (21).

7. Displacement sensor according to one of the preceding claims 1 to 4,
wherein the displacement sensor (1) has a first magnetic field sensor (21) and a third magnetic field sensor (23) as well as a second magnetic field sensor (22) arranged between the first magnetic field sensor (21) and the third magnetic field sensor (23) and
the calculation unit (11) is configured to determine the selected magnetic field sensor (12) by
acquiring a value by the output signal (S) of the second magnetic field sensor (22), which corresponds to the position (P) of the magnet (M) along the magnetic field sensor axis (20) of the second magnetic field sensor (22) and
determining the second magnetic field sensor (22) to be the selected magnetic field sensor (12) if the position (P) corresponding to the value is within the displacement measurement range (24) of the second magnetic field sensor (22) and
determining the first magnetic field sensor (21) to be the selected magnetic field sensor (12) if the position (P) corresponding to the value is located on a side facing the first magnetic field sensor (21) outside the displacement measurement range (24) of the second magnetic field sensor (22) and
determining the third magnetic field sensor (23) to be the selected magnetic field sensor (12) if the position (P) corresponding to the value is located on a side facing the third magnetic field sensor (23) outside the displacement measurement range (24) of the second magnetic field sensor (22).

8. Sensor arrangement (2) with a central calculation unit and a plurality of sensors (111, 112, 113),
wherein at least two sensors (111) of the plurality of sensors (111, 112, 113) are displacement sensors (1) according to one of the preceding claims 1 to 7,
and wherein the calculation units (11) of the displacement sensors (1) are integrated in the central calculation unit and the plurality of magnetic field sensors (21, 22, 23) of the displacement sensors (1) are connected or connectable to the central calculation unit.

9. Sensor arrangement (2) with a central calculation unit and a plurality of sensors (111, 112, 113), in particular according to the preceding claim,
wherein the sensor arrangement (2) has a housing base (210) and, for each sensor (111, 112, 113), a sensor carrier (211) with at least one sensor mount (212) on which the respective sensor (111, 112, 113) is held at a predetermined distance from the housing base (210) and/or at a predetermined detection distance from an object to be detected by the respective sensor (111, 112, 113).

10. Sensor arrangement according to the preceding claim,
wherein at least one sensor carrier (211) has a first sensor mount (212) on which the respective sensor (111, 112, 113) can be arranged essentially parallel to a plane defining the housing base (210), and a second sensor mount on which the respective sensor (111, 112, 113) can be arranged tilted, in particular orthogonally to the plane.

11. Sensor arrangement according to one of the two preceding claims,
comprising an integrally formed rigid-flex printed circuit board (220) with a rigid central section (221) on which the central calculation unit is arranged or with which the central calculation unit is connectable, and a rigid sensor section (222) per sensor (111, 112, 113), each of which is electrically connected to the central section (221) via a flexible connection section (223),
wherein rigid-flex printed circuit board (220) is configured to be pre-assembled and mounted with the sensors (111, 112, 113) connectable to the central calculation unit in such a way that the central section (221) is arranged on the housing base (210) and the sensor sections (222) are each arranged on a corresponding sensor mount (212).

12. Sensor arrangement according to one of claims 9 to 11,
further comprising a main housing (230) which is arranged on the housing base (210) and encloses at least one of the sensors (111, 112, 113),
wherein the main housing (230) has a receiving pot (231) for each enclosed sensor (111, 112, 113), which forms a hollow, liquid-tight sensor chamber (232) receiving the respective sensor (111, 112, 113).

13. Sensor arrangement according to the preceding claim,
wherein at least one opening (213) is provided in the housing base (210), which is connected fluidically to at least one sensor chamber (232),
wherein, in particular, exactly one opening (213) is provided per sensor chamber (232), which is connected fluidically with the respective sensor chamber (232) through the respective sensor carrier (211),
so that a sealing compound, which can be cured in the sensor chamber (232), can be filled into the sensor chamber (232) through the opening (213), in particular by gravity, which completely encloses the sensor (111, 112, 113) arranged in the sensor chamber.

14. Sensor arrangement according to one of the two preceding claims,
wherein a sealing portion (233) surrounding the receiving pot (231) is formed on an outer side of at least one of the receiving pots (231) facing away from the sensor chamber (232) and/or on an area of the main housing (230) adjacent to a base of at least one of the receiving pots (231), by means of which the receiving pot (231) can be inserted in a liquid-tight manner into a corresponding opening.

15. Sensor arrangement according to one of claims 8 to 14,
wherein at least one of the plurality of sensors (111, 112, 113) is a temperature sensor (112) and/or
wherein at least one of the plurality of sensors (111, 112, 113) is a speed sensor (113).
